# EUROPÄISCHE PATENTSCHRIFT

(11) **EP 0 783 794 B1**
(45) Veröffentlichungstag und Bekanntmachung des Hinweises auf die Patenterteilung: **02.12.1998**
(21) Anmeldenummer: 95929779.7
(22) Anmeldetag: 08.09.1995
(51) Int. Cl.: H03D 1/22

(54) **Verfahren zur Amplituden-Demodulation**
Method for Amplitude Demodulation
Procédé de Démodulation d'Amplitude

(30) Priorität: 27.09.1994 DE 4434451
(43) Veröffentlichungstag der Anmeldung: 16.07.1997
(73) Patentinhaber: Blaupunkt-Werke GmbH, 31132 Hildesheim (DE)
(72) Erfinder: CHAHABADI, Djahanyar, D-31139 Hildesheim (DE)
(74) Vertreter: Friedmann, Jürgen, Dr.-Ing.
(86) Internationale Anmeldenummer: DE9501227
(87) Internationale Veröffentlichungsnummer: WO9610290

(56) Entgegenhaltungen:
- EP-A- 0 540 195
- EP-A- 0 564 850
- WO-A-86/05936

## Beschreibung

Die Erfindung betrifft ein Verfahren, zur Demodulation eines quadratur-amplituden-modulierten Stereosignals für Rundfunkempfänger.

Aufgabe der vorliegenden Erfindung ist es, ein Amplituden-Demodulations-Verfahren für Rundfunkempfänger anzugeben, welches weitgehend in digitaler Technik in einfacher Weise ausführbar ist, so daß ein digital realisierter Amplitudendemodulator zur Durchführurg des erfindungsgemäßen Demodulationsverfahrens von den im Rundfunkempfänger vorhandenen Taktsignalen Gebrauch machen kann.

Aus der EP-A-O 540 195 ist ein digitaler Rundfunkempfänger für quadratur-amplitudenmodulierte Signale bekannt, bei dem das Empfangssignal nach Digitalisierung in einer ersten Schaltungseinheit gemischt, gefiltert und in der Abtastrate reduziert wird, worauf an deren Ausgang Inphase- und Quadraturkomponente des Signals vorliegen. Durch Hüllkurvendetektion und Entfernung des DC-Anteils wird daraus das Stereo-Summensignal (L+R) gebildet, während das Stereo-Differenzsignal (L-R) durch erneutes Mischen und Quadratur-Amplituden-Modulation-Konvertierung erzeugt wird.

Das erfindungsgemäße Demodulationsverfahren mit den Merkmalen des Hauptanspruchs hat den Vorteil, daß zum Empfang von AM-Stereo-Sendungen, bei welchen eine Quadratur-Amplitudenmodulation des Trägers vorgenommen wird, die Referenzfrequenz bei der Abstimmung nicht an die Frequenz des unmodulierten Trägers gekoppelt werden muß. Eine solche Kopplung ist beispielsweise bekannt aus IEEE Transactions on Consumer Electronics, Vol. 40, No. 1, Februar 1994, Seiten 64 bis 74.

Bei dieser Weiterbildung ist insbesondere vorgesehen, daß das Phasensignal vor der Tangensbildung bezüglich Frequenz- und Phasenabweichungen des ins Basisband umgesetzten Zwischenfrequenzsignals korrigiert wird. Dabei erfolgt die Frequenzkorrektur durch eine Steuerung anstelle einer Regelung.

Eine vorteilhafte Möglichkeit zur Korrektur bezüglich Frequenzabweichungen besteht darin, daß vom Phasensignal ein Korrektursignal subtrahiert wird, das durch Messung der zeitlichen Änderung des Phasensignals, anschließende Tiefpaßfilterung und Integration des tiefpaßgefilterten Signals abgeleitet wird.

Ferner kann bei dieser Weiterbildung vorgesehen sein, daß von dem bezüglich der Frequenzabweichung bereits korrigierten Phasensignal ein weiteres Korrektursignal subtrahiert wird, das durch Tiefpaßfilterung des bezüglich der Frequenz korrigierten Phasensignals abgeleitet wird.

Da in einem für die Bildung des Betragssignals und des Phasensignals vorgesehenen Rechenwerk die Phase auf einen Winkel zwischen -π und +π beschränkt ist, ist bei einer vorteilhaften Ausgestaltung dieser Weiterbildung vorgesehen, daß dem bereits bezüglich der Frequenzabweichung korrigierten Phasensignal ein weiteres Korrektursignal hinzugefügt wird, das zwei verschiedene Pegel einnehmen kann, welche Phasenabweichungen entsprechen, die um n voneinander verschieden sind, und daß das weitere Korrektursignal durch Betragsbildung und Tiefpaßfilterung des bezüglich der Frequenzabweichung korrigierten Phasensignals und mit Hilfe einer anschließenden Schwellwertschaltung mit Hysterese gebildet wird.

Eine weitere vorteilhafte Möglichkeit zur Ableitung des Stereo-Differenzsignals aus dem Phasensignal besteht darin, daß dem die zeitliche Änderung des Phasensignals kennzeichnenden und anschließend tiefpaßgefilterten Signal ein Rückkopplungssignal zugeführt wird, das aus dem Stereo-Differenzsignal durch Tiefpaßfilterung gewonnen wird, und daß das bezüglich der Frequenzabweichung korrigierte Phasensignal über einen Begrenzer zur Tangensbildung geleitet wird.

Hierbei ist der Gleichanteil des Stereo-Differenzsignals nur vom Phasenfehler abhängig. Dadurch wird durch diese Möglichkeit ein besonders niedriger Klirrfaktor erzielt.

Ausführungsbeispiele der Erfindung sind in der Zeichnung anhand mehrerer Figuren in Form von Blockschaltbildern dargestellt und in der nachfolgenden Beschreibung näher erläutert. Es zeigt:
- Fig. 1: ein Ausführungsbeispiel für Mono-Empfang,
- Fig. 2: ein Ausführungsbeispiel für Stereo-Empfang,
- Fig. 3: ein Teil der Schaltungsanordnung nach Fig. 2 zur Stereo-Demodulation in detaillierterer Darstellung,
- Fig. 4: ein Tiefpaßfilter aus der Schaltungsanordnung nach Fig. 3,
- Fig. 5: einen Decoder für die Phasenlage des nach Betrag und Phase demodulierten Zwischenfrequenzsignals,
- Fig. 6: Beispiele für in der Schaltungsanordnung nach Fig. 2 verwendeter spezieller Tiefpaßfilter,
- Fig. 7: eine Schaltungsanordnung zur Berechnung des Tangens,
- Fig. 8: ein Pilottonfilter zur Detektion des 25-Hz-Pilottons,
- Fig. 9: eine Schaltungsanordnung zur Bildung eines frequenzproportionalen Signals aus dem Phasensignal,
- Fig. 10: eine Korrekturschaltung,
- Fig. 11: eine Schaltung zur Ermittlung und Korrektur eines Phasenfehlers,
- Fig. 12: ein weiteres Ausführungsbeispiel zur Decodierung des Phasensignals und
- Fig. 13: ein weiteres Tiefpaßfilter.

Gleiche Teile sind in den Figuren mit gleichen Bezugszeichen versehen.

Die Ausführungsbeispiele sowie Teile davon sind zwar als Blockschaltbilder dargestellt. Dieses bedeutet jedoch nicht, daß die erfindungsgemäße Schaltungsanordnung auf eine Realisierung mit Hilfe von einzelnen den Blöcken entsprechenden Schaltungen beschränkt ist. Die erfindungsgemäße Schaltungsanordnung ist vielmehr in besonders vorteilhafter Weise mit Hilfe von hochintegrierten Schaltungen realisierbar. Dabei kann beispielsweise ein digitaler Signalprozessor eingesetzt werden, welcher bei geeigneter Programmierung die im Blockschaltbild dargestellten Verarbeitungsschritte durchführt. Die erfindungsgemäße Schaltungsanordnung kann zusammen mit weiteren Schaltungsanordnungen innerhalb einer integrierten Schaltung wesentliche Teile eines Rundfunkempfängers bilden.

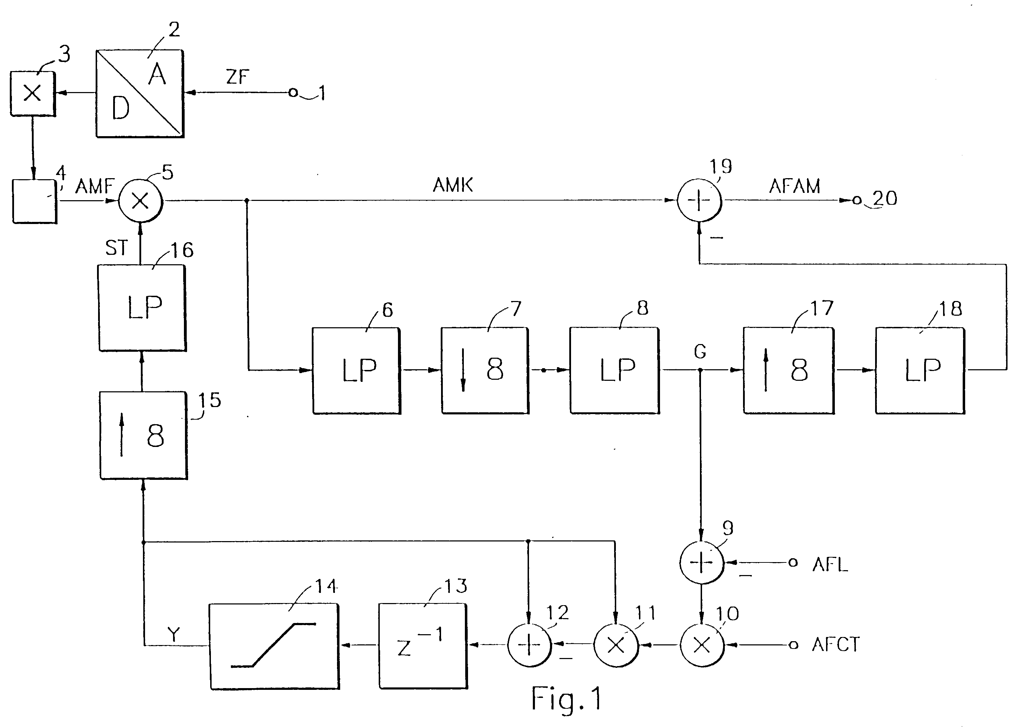

Dem Amplitudendemodulator nach Fig. 1 wird bei 1 ein Zwischenfrequenzsignal zugeführt, das in einem Analog/Digital-Wandler 2 mit einer Frequenz von 14,25 MHz abgetastet und in ein digitales Zwischenfrequenzsignal umgewandelt wird. In einem anschließenden Mischer 3 wird dieses Signal ins Basisband gemischt und demoduliert. Dabei kann es zweckmäßig sein, die ursprüngliche Abtastrate von 14,25 MHz auf ein für die weitere Verarbeitung des Niederfrequenzsignals erforderliche Abtastfrequenz herabzusetzen, beispielsweise auf 45,6 kHz. Das Ausgangssignal des Amplitudendemodulators beinhaltet außer der NF-Nutzinformation noch einen Gleichanteil, der von der Amplitude des unmodulierten AM-Trägers herrührt. Hiervon ist auch die Amplitude des Ausgangssignals AMF des Demodulators abhängig. Zur Kompensation dieser Abhängigkeit ist ein Multiplizierer 5 vorgesehen, der das Signal AMF mit einer Stellgröße ST multipliziert. Diese Stellgröße wird, wie im folgenden beschrieben, aus dem Gleichanteil des Signals AMF gewonnen.

Zur Ableitung des Gleichanteils wird das Ausgangssignal des Multiplizierers 5 tiefpaßgefiltert. Da die Tiefpaßfilterung des Gleichanteils schmalbandig sein soll, so daß die Regelung nicht auf niederfrequente Anteile des NF-Signals anspricht, ist eine niedrige Grenzfrequenz erforderlich. Dazu wird das Ausgangssignal AMK des Multiplizierers 5 bei 6 ein erstes Mal tiefpaßgefiltert, dann bezüglich der Abtastrate bei 7 um den Faktor acht dezimiert und schließlich bei 8 ein zweites Mal tiefpaßgefiltert. Der am Ausgang des Tiefpaßfilters 8 anstehende Gleichanteil G ist zunächst einer Pegel- und Zeitkonstanteneinstellung für die Regelung unterworfen. Dazu sind ein Subtrahierer 9 und ein Multiplizierer 10 vorgesehen, denen Einstellgrößen AFL und AFCT für den Pegel und die Zeitkonstante der Regelung zuführbar sind.

Der somit beeinflußte Gleichanteil wird mit Hilfe eines Gradientenverfahrens in die Stellgröße ST umgewandelt. Dazu wird der Gleichanteil über einen weiteren Multiplizierer 11 und einen weiteren Subtrahierer 12 zu einer Verzögerungseinrichtung 13 um eine Abtastperiode des Gleichanteils G geleitet. An die Verzögerungseinrichtung 13 schließt sich ein Begrenzer 14 an, dessen Ausgangssignal y beidseitig begrenzt ist. Aufgabe des Begrenzers ist es, den Pegelbereich festzulegen, der ausgeregelt werden soll. Der Begrenzer 14 kann auch vor der Verzögerungseinrichtung angeordnet sein. Als Stellgröße kann dann auch das unverzögerte begrenzte Signal verwendet werden.

Das Ausgangssignal y des Begrenzers wird dann bei 15 und 16 zur Heraufsetzung der Abtastrate interpoliert und tiefpaßgefiltert und als Stellgröße ST dem Multiplizierer 5 zugeführt.

Um aus dem Signal AMK den Gleichanteil zu entfernen, wird der Gleichanteil G nach einer Interpolation bei 17 und einer Tiefpaßfilterung bei 18 einem Subtrahierer 19 zugeführt, an dessem Ausgang 20 das demodulierte NF-Signal AFAM entnehmbar ist.

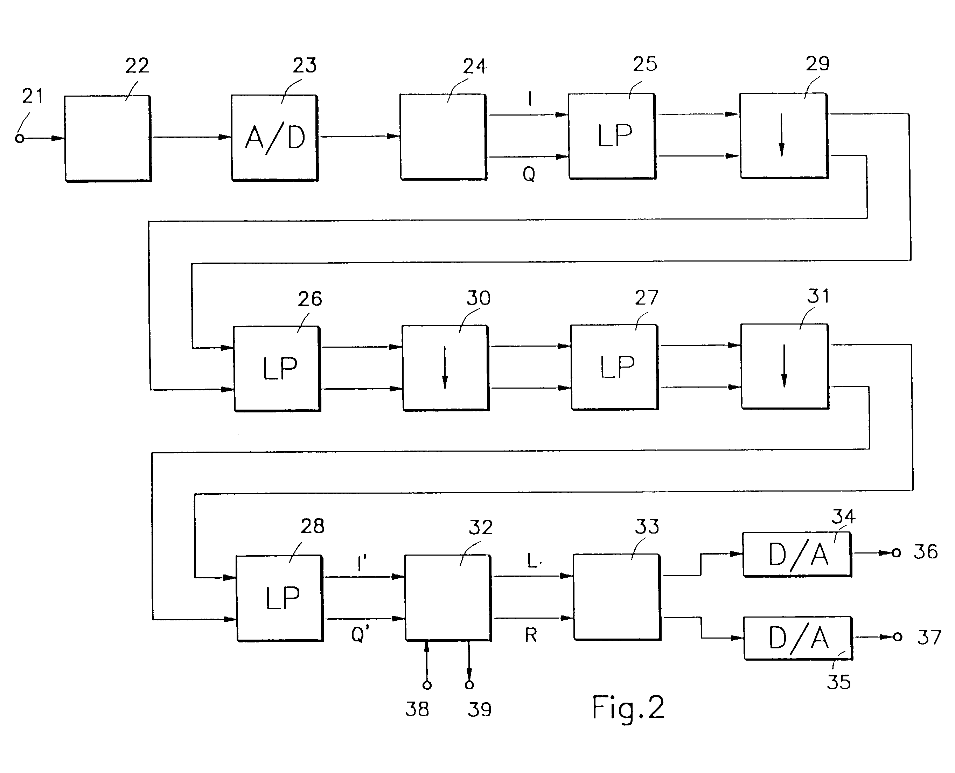

Mit den in den Figuren 2 bis 13 dargestellten Ausführungsbeispielen ist ein Empfang von durch Quadratur-Amplitudenmodulation übertragenen Stereosignalen möglich.

Das in Fig. 2 dargestellte Ausführungsbeispiel erhält ein analoges Zwischenfrequenzsignal bei 21, das über eine Abtast- und Halteschaltung 22 einem Analog/Digital-Wandler 23 zugeführt wird. Der Ausgang des Analog/Digital-Wandlers ist mit einem Mischer 24 verbunden, mit welchem in an sich bekannter Weise das digitale Zwischenfrequenzsignal mit zwei orthogonalen Mischsignalen gemischt wird, so daß zwei Komponenten I und Q entstehen. Dieses Signal wird schrittweise tiefpaßgefiltert und bezüglich seiner Abtastrate dezimiert, wofür insgesamt vier Tiefpaßfilter 25, 26, 27, 28 und drei Dezimationsstufen 29, 30, 31 vorgesehen sind.

Mit der Dezimationsstufe 29 wird die Abtastrate des digitalen Zwischenfrequenzsignals zunächst auf 456000 1/s dezimiert. Die Dezimationsstufe 30 bewirkt eine Abtastrate von 228000 1/s, während die Dezimationsstufe 31 eine Abtastrate von 45600 1/s zur Folge hat. Durch die Filterung mit dem Tiefpaß 28 wird das komplexe Basisbandsignal des Nutzkanals von Nutz- und Störsignalen der Nachbarkanäle befreit.

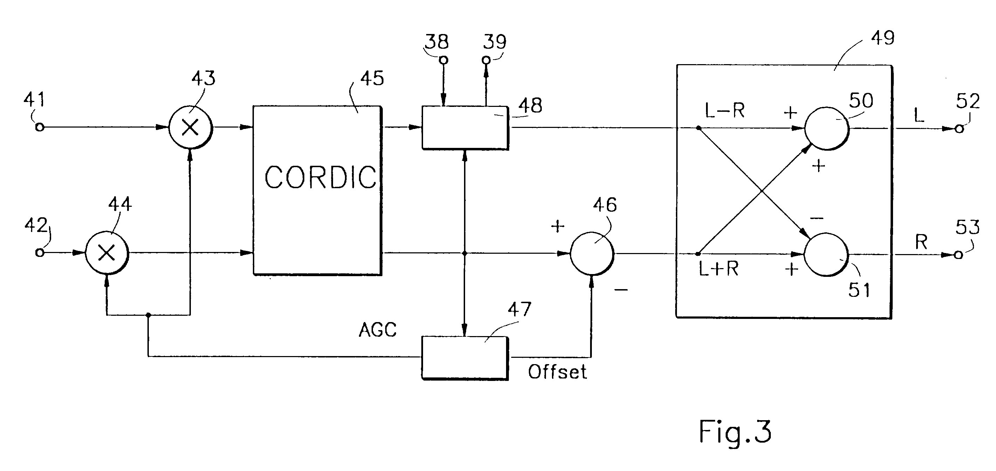

Die Komponenten I' und Q' werden dann einem Stereo-Demodulator 32 zugeleitet, der im einzelnen in Fig. 3 erläutert ist und an seinem Ausgang die Audiosignale L und R führt. Diese werden über eine Schaltung 33 zur Audioverarbeitung und über Digital/Analog-Wandler 34, 35 Ausgängen 36, 37 der Schaltungsanordnung nach Fig. 2 zugeleitet. Die Schaltung 33 zur Audioverarbeitung enthält beispielsweise Lautstärke- und Klangsteller.

Dem Stereo-Demodulator 32 ist über einen Eingang 38 ein Mono/Stereo-Umschaltsignal zuführbar. An dem Ausgang 39 kann ein Signal zur Anzeige des Pilottons, der Pilottonindikator, zugeführt werden.

Fig. 3 zeigt den Stereo-Demodulator 32 (Fig. 2) in detaillierterer Darstellung. Der Realteil I' und der Imaginärteil Q' werden von Eingängen 41, 42 je einem Multiplizierer 43, 44 zur Dynamikregelung mit Hilfe eines Signals AGC zugeführt. Die in ihrer Dynamik geregelten Signale gelangen zu Eingängen eines Rechenwerks 45 zur Bildung des CORDIC-Algorithmus, wodurch ein Signal B, das dem Betrag, und ein Signal P entsteht, das der Phase entspricht. Das Betragssignal B enthält das Summensignal L+R sowie einen Gleichanteil. Das Phasensignal P enthält eine Kombination aus dem Differenzsignal L-R, dem Pilotton und dem Summensignal L+R. In einem Subtrahierer 46 wird das Betragssignal vom Gleichanteil, der durch das Mischen des Trägersignals auf die Frequenz 0 entsteht, befreit. Dieser Gleichanteil wird in einer Regelschaltung 47 unter Bildung eines Signals Offset und eines Signals AGC abgeleitet. Ferner kann der Gleichanteil zur Mono/Stereo-Überblendung und zur Realisierung einer Suchlauf/Stopp-Funktion dienen, um den Sendesuchlauf zu steuern, was in Fig. 3 nicht dargestellt ist.

Ein Decoder 48 - im folgenden Q-Decoder genannt - für das Phasensignal P erzeugt das Differenzsignal L-R. Dieses wird zusammen mit dem vom Gleichanteil befreiten Summensignal L+R einer Matrix 49 zugeführt, die aus einem Addierer 50 und einem Subtrahierer 51 besteht und an deren Ausgängen 52, 53 die Signale L und R abnehmbar sind. Dem Q-Decoder 48 ist über den Eingang 38 ein Mono/Stereo-Umschaltsignal zuführbar. Dem Eingang 39 kann der Pilottonindikator entnommen werden.

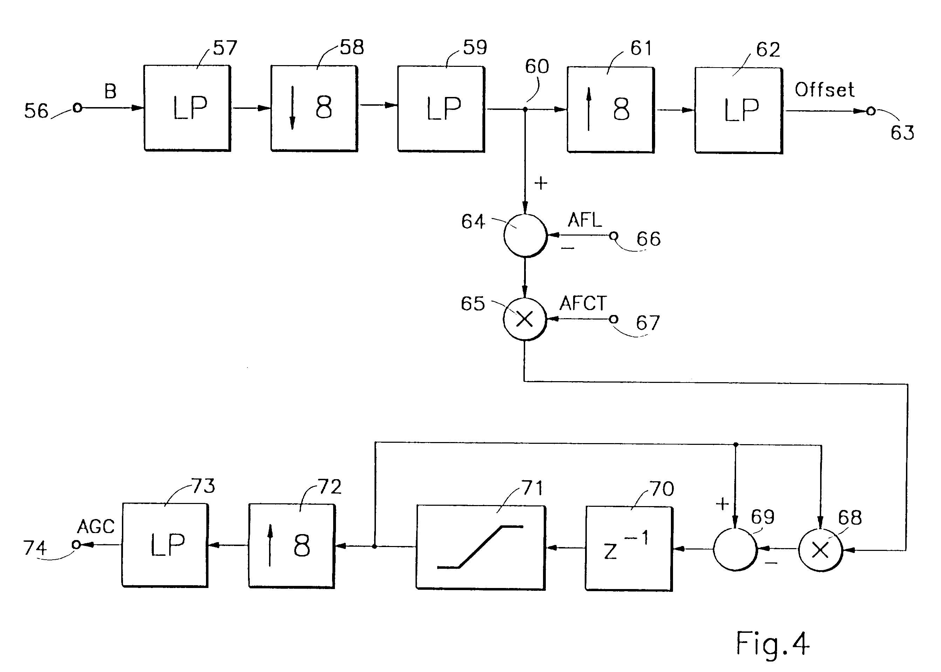

Fig. 4 zeigt eine detailliertere Darstellung der Regelschaltung 47 (Fig. 3). Die Abtastrate des bei 56 zugeführten Betragssignals B beträgt 45600 Hz und wird nach Tiefpaßfilterung 57 bei 58 um den Faktor 8 auf 5700 Hz dezimiert. Eine anschließende weitere Tiefpaßfilterung 59 unterdrückt das Summensignal, so daß am Schaltungspunkt 60 lediglich der Gleichanteil zur Verfügung steht. Eine anschließende Heraufsetzung der Abtastrate bei 61 um den Faktor 8 und eine Tiefpaßfilterung 62 ergibt das Signal Offset, das vom Ausgang 63 dem Subtrahierer 46 (Fig. 3) zugeführt wird. Die Abtastratendezimierung und anschließende Heraufsetzung ermöglicht die zur Bildung des Signals Offset erforderliche Tiefpaßfilterung 59 bei einer niedrigen Grenzfrequenz mit geringem Filteraufwand.

Zur Erzeugung des Signals AGC wird das den Gleichanteil darstellende Signal vom Schaltungspunkt 60 über einen Subtrahierer 64 und einen Multiplizierer 65 geleitet. Dem Subtrahierer wird über einen Eingang 66 ein Signal AFL zugeführt, mit dem eine Einstellung des Sollpegels für die Dynamikregelung erfolgt. Mit Hilfe eines einem weiteren Eingang 67 zugeführten Signals AFCT kann eine Einstellung der Zeitkonstanten für die Dynamikregelung vorgenommen werden. Das somit bezüglich seines Gleichanteils und seiner Amplitude beeinflußte Gleichanteil-Signal wird in den nachfolgenden Schaltungen einer Verarbeitung nach dem Gradienten-Verfahren unterworfen, wobei das AGC-Signal soweit nachgeführt wird, bis der gewünschte Pegel sich einstellt.

Dazu wird der Gleichanteil über einen weiteren Multiplizierer 68 und einen weiteren Subtrahierer 69 zu einer Verzögerungseinrichtung 70 um eine Abtastperiode des Gleichanteils G geleitet. An die Verzögerungseinrichtung 70 schließt sich ein Begrenzer 71 an, dessen Ausgangssignal beidseitig begrenzt ist. Aufgabe des Begrenzers ist es, den Pegelbereich festzulegen, der ausgeregelt werden soll. Der Begrenzer 71 kann auch vor der Verzögerungseinrichtung angeordnet sein. Als Stellgröße kann dann auch das unverzögerte begrenzte Signal verwendet werden.

Das Ausgangssignal des Begrenzers 71 wird dann bei 72 und 73 zur Heraufsetzung der Abtastrate interpoliert und tiefpaßgefiltert und über den Ausgang 74 als Stellgröße AGC den Multiplizierern 43, 44 (Fig. 3) zugeführt.

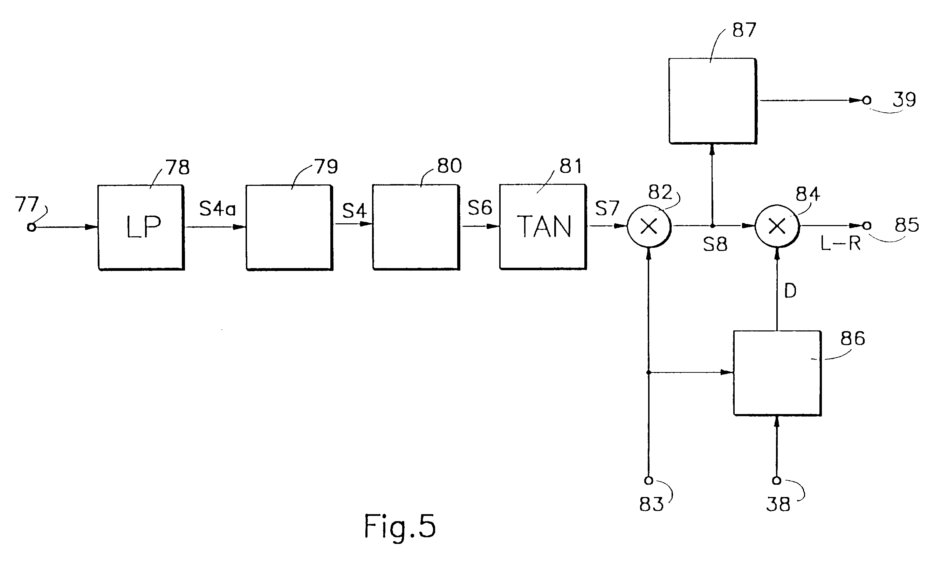

Die bisher beschriebenen Schaltungsteile sind auch für die Demodulation von Mono-Signalen erforderlich. Bei Stereo-Signalen liefert der Q-Decoder 48 (Fig. 3) das Differenzsignal L-R. Fig. 5 zeigt ein Ausführungsbeispiel des Q-Decoders. Einem Eingang 77 wird das Phasensignal P vom Ausgang des Rechenwerks 45 (Fig. 3) zugeführt. Es folgen drei Korrekturschaltungen, nämlich zur Frequenzkorrektur 78, zur n-Korrektur 79 und zur Phasenkorrektur 80. Diese sind erforderlich, da bei dem erfindungsgemäßen Empfänger die Abstimmung anhand einer aus einem Quarztakt gewonnenen Referenzfrequenz erfolgt, die in der Regel nicht exakt mit der unmodulierten Trägerfrequenz des Senders übereinstimmt. Es ist dabei von einer Frequenzablage bis zu einigen 100 Hz auszugehen, so daß das Phasensignal P zunächst eine Frequenz-, dann eine n- und schließlich eine Phasenkorrektur durchlaufen muß.

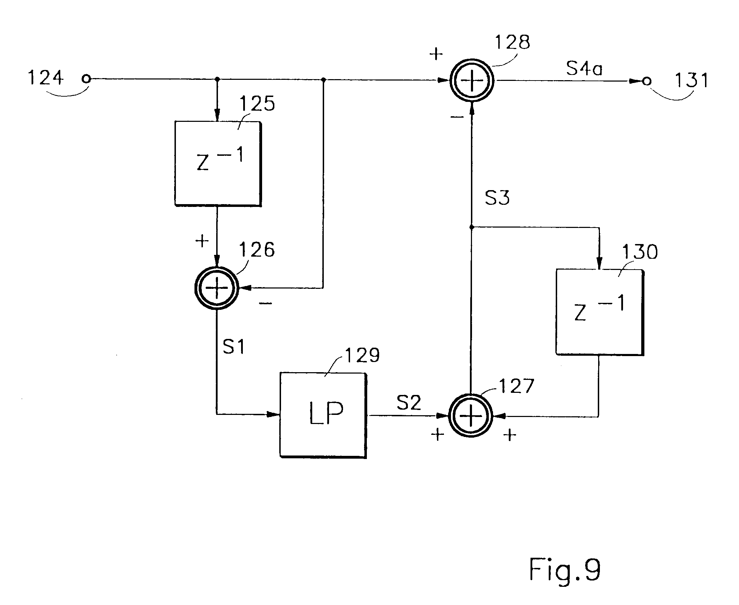

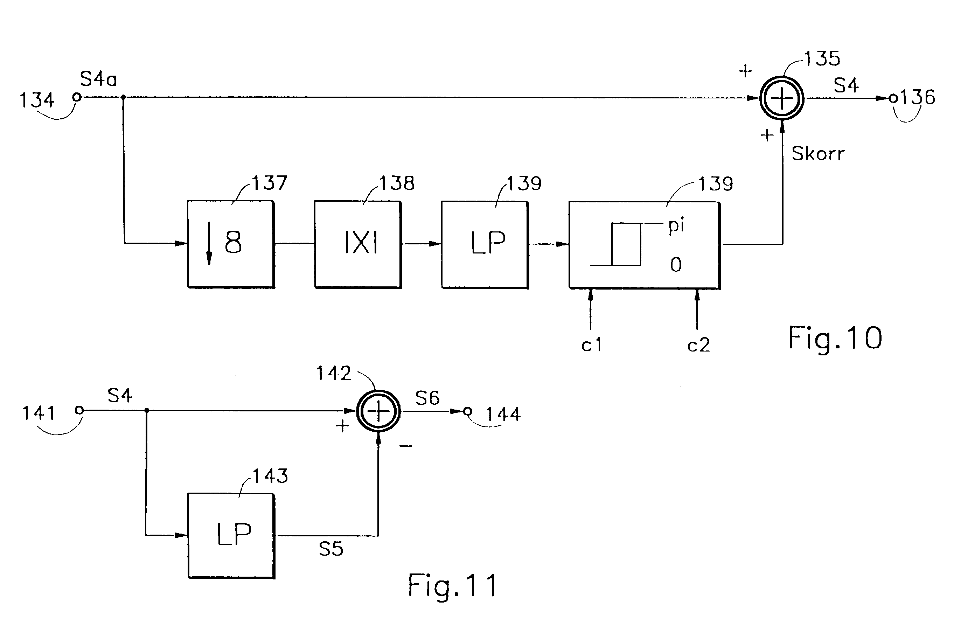

Einzelheiten der Schaltung 78 zur Frequenzkorrektur sind in Fig. 9 dargestellt, Einzelheiten der π-Korrektur 79 in Fig. 10 und Einzelheiten der Phasenkorrektur 80 in Fig. 11. Aus dem somit korrigierten Phasensignal P wird bei 81 der Tangens erzeugt. Dieses Signal S7 wird bei 82 mit dem bei 83 zugeführten Betragssignal B multipliziert, wodurch ein Signal S8 entsteht, das an sich dem Differenzsignal L-R entspricht. Zur Steuerung der Kanaltrennung wird dieses bei 84 mit einem Signal D mulipliziert und ist an einem Ausgang 85 abnehmbar. Bei der Schaltungsanordnung nach Fig. 3 wird es vom Ausgang 85 der Matrix 49 zugeleitet.

Das Signal D wird in einer Schaltung 86 erzeugt, kennzeichnet die Qualität des empfangenen Signals und ist abhängig von dem bei 38 zugeführten Mono/Stereo-Umschaltsignal und dem Betragssignal B. Das Mono/Stereo-Umschaltsignal bewirkt in einer von Hand eingebbaren Stellung Mono, daß das Signal und damit auch das Differenzsignal L-R gleich 0 werden. Die Abhängigkeit des Signals D vom Betragssignal B kann beispielsweise derart sein, daß das Betragssignal über einen größeren Zeitraum integriert wird und daß D umso kleiner ist, je mehr das integrierte Betragssignal B unterhalb einer vorgegebenen Schwelle liegt, da dann auch von einem schlechten Störabstand ausgegangen werden kann.

Das Ausgangssignal des Multiplizierers 82 enthält ferner den Pilotton. Aus diesem wird mit Hilfe eines Pilottonfilters 87 der Pilottonindikator abgeleitet, der am Ausgang 39 zur Verfügung steht.

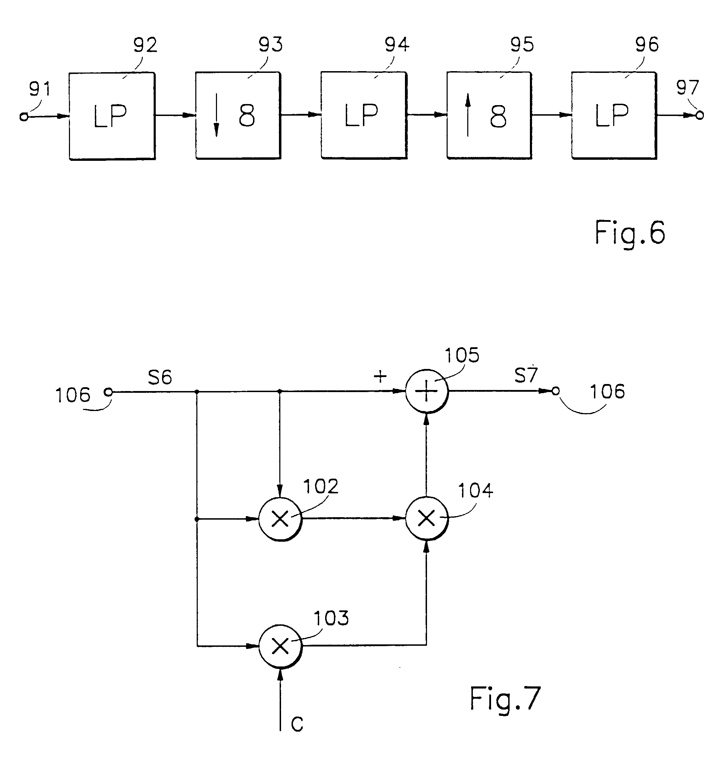

In den Schaltungen 78 und 80 (Fig. 5) sind Tiefpaßfilter mit einer sehr niedrigen Grenzfrequenz erforderlich. Eine dafür geeignete Struktur ist in Fig. 6 dargestellt. Das zu filternde Signal wird einem Eingang 91 zugeführt, durchläuft dann ein Tiefpaßfilter 92, eine Abtastratendezimierung 93, ein weiteres Tiefpaßfilter 94, eine Interpolation 95 zur Heraufsetzung der Abtastrate und ein drittes Tiefpaßfilter 96. Das gefilterte Signal kann einem Ausgang 97 entnommen werden. Die Tiefpaßfilter 92 und 96 sind als Kammfilter ausgebildet, während das Tiefpaßfilter 94 von einer Kettenschaltung zweier IIR-Filter erster Ordnung realisiert wird.

Fig. 7 zeigt Einzelheiten der Schaltung 81 (Fig. 5) zur Bildung der Tangensfunktion des Signals S6 durch eine Taylorreihe dritter Ordnung. Dazu wird das bei 101 zugeführte Signal S6 bei 102 mit sich selbst und bei 103 mit einer Konstanten c multipliziert. Beide Produkte werden dann bei 104 miteinander multipliziert, so daß ein Koeffizient dritter Ordnung entsteht. Dieser wird bei 105 dem Signal S6 hinzuaddiert. Das Ergebnis S7 kann einem Ausgang 106 entnommen werden.

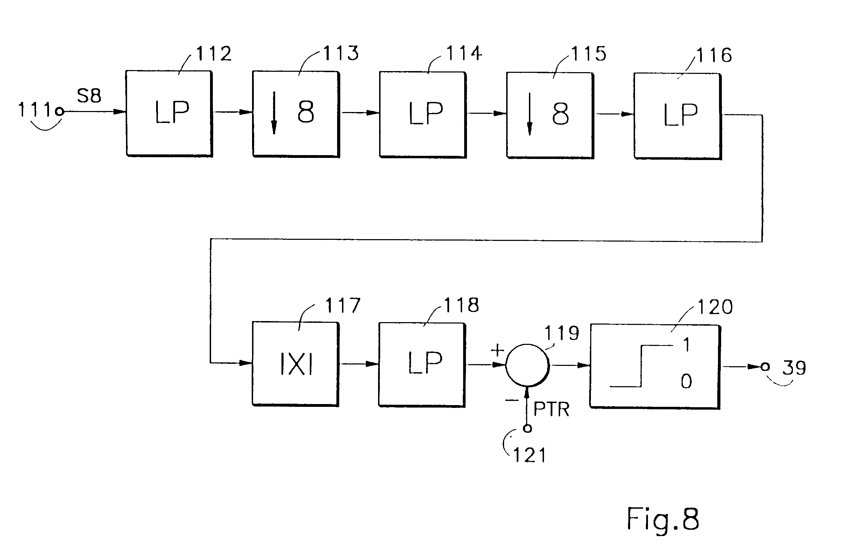

Fig. 8 stellt ein Ausführungsbeispiel für ein Pilottonfilter 87 (Fig. 5) dar. Das Signal S8 wird einem Eingang 111 zugeleitet und nach Tiefpaßfilterung bei 112 einer Abtastratendezimierung 113 unterworfen. Darauf folgt eine weitere Tiefpaßfilterung 114 und eine weitere Abtastratendezimierung 115. Nach einer dritten Tiefpaßfilterung 116 liegt ein sehr schmalbandig gefilterter Pilotton vor. Damit sind Störungen durch einen im Differenzsignal verbliebenen Gleichanteil sowie durch das Differenzsignal L-R selbst ausgeschlossen. Die Filter 112 und 114 sind jeweils als Kammfilter ausgebildet.

Um den Pegel des Pilottons zu ermitteln, wird bei 117 der Betrag des gefilterten Pilottons gebildet und mit einem IIR-Filter zweiter Ordnung 118 tiefpaßgefiltert. Mit Hilfe eines Subtrahierers 119 und einer anschließenden Schwellwertschaltung 120 wird der Pegel des Pilottons mit einer bei 121 zugeführten Schwelle PTR verglichen. Diese Schwelle ist beispielsweise von einem den gesamten Empfänger steuernden Prozessor (Geräteprozessor) programmierbar. Wird die Schwelle überschritten, dann wird ein Pilotton erkannt und der Pilottonindikator - das am Ausgang 39 abnehmbare Signal - auf 1 gesetzt. Anderenfalls nimmt der Pilottonindikator den Wert 0 an. Über den Pilottonindikator wird dem Geräteprozessor mitgeteilt, ob eine stereophone Sendung empfangen wird.

Fig. 9 zeigt die Schaltung 78 (Fig. 5) zur Frequenzkorrektur. Diese dient dazu, die Frequenzablage zu korrigieren, welche dadurch entsteht, daß die Abstimmung des erfindungsgemäßen Empfängers anhand einer aus einem Quarztakt gewonnenen Referenzfrequenz vorgenommen wird, die in der Regel nicht exakt mit der unmodulierten Trägerfrequenz des Senders übereinstimmt.

Zur Korrektur der Frequenzablage wird aus dem Phasensignal P, das bei 124 zugeführt wird, ein frequenzproportionales Signal S1 gebildet. Dazu wird das Phasensignal bei 125 um eine Abtastperiode verzögert und vom verzögerten Phasensignal subtrahiert. Da in dem Rechenwerk 45 (Fig. 3) die Phase auf den Winkelbereich von -π bis +π beschränkt ist, bzw. bei normierter Darstellung auf Werte -1≤Phase/π≤=1-1LSB beschränkt ist, müssen Winkeldifferenzen (oder -summen), die diesen Wertebereich verlassen, um 2n bzw. um 2 korrigiert werden. Dieses Überlaufverhalten (englisch "Wrap-around") ist mit einem Rechenwerk leicht realisierbar und entspricht einer Modulo-Arithmetik. In Fig. 9 sind diese Operationen als Addierer 126, 127, 128 mit zwei konzentrischen Kreisen gekennzeichnet - im Gegensatz zu Addierern, die beim Überlauf ein Sättigungsverhalten voraussetzen, beispielsweise in Fig. 4.

Das frequenzproportionale Signal S1 wird mit Hilfe eines Tiefpasses 129 von Wechselanteilen befreit, wodurch das Signal S2 entsteht. Durch Integration des Gleichanteils S2 mit einem Modulo-Addierer 127 und einer Verzögerung 130 um eine Abtastperiode entsteht das Signal S3, das den durch den Frequenzversatz entstandenen Phasenfehler bis auf einen konstanten Phasenfehler beschreibt. Dieses wird von dem Phasensignal P bei 128 subtrahiert. Das korrigierte Signal wird von einem Ausgang 131 als Signal S4a der Schaltung 79 (Fig. 5) zugeleitet.

Die in Fig. 10 dargestellte Schaltung fügt dem einen Winkel darstellenden Signal S4a am Eingang 134 über den Modulo-Addierer 135 ein Signal Skorr zu. Das Signal Skorr kann den Wert π oder 0 annehmen. Das korrigierte Signal S4 steht am Ausgang 136 zur Verfügung. Eine Korrektur um π wird durchgeführt, wenn der Betrag des Signals S4a im Mittel einen vorgegebenen Winkel c2 überschreitet. Diese Korrektur wird wieder zurückgenommen, falls nach Überschreiten von c2 der Winkel den Wert c1 unterschreitet. Die somit realisierte Hysterese unterbindet ein unentwegtes Umschalten von Skorr zwischen 0 und π. Nach einer Abtastratendezimierung um den Faktor 8 bei 137 wird bei 138 der Betrag gebildet, der über ein IIR-Tiefpaßfilter erster Ordnung 139 geführt wird. Bei 140 wird die bereits beschriebene Hysterese mit den beiden Schwellen c1 und c2 gebildet.

Der nach der Phasenkorrektur 79 (Fig. 5) verbliebene Phasenfehler des Signals S4 wird mit Hilfe der Schaltung 80, die in Fig. 11 dargestellt ist, korrigiert. Vom Eingang 141 wird das Signal S4 einerseits einem Modulo-Addierer 142 und andererseits einem Tiefpaßfilter 143 zugeleitet. Das tiefpaßgefilterte Signal S5 wird von dem Signal S4 subtrahiert, so daß am Ausgang 144 das korrigierte Signal S6 ansteht. Das Tiefpaßfilter 143 kann ebenso wie das Tiefpaßfilter 129 (Fig. 9) mit Hilfe der in Fig. 6 dargestellten Schaltung realisiert werden.

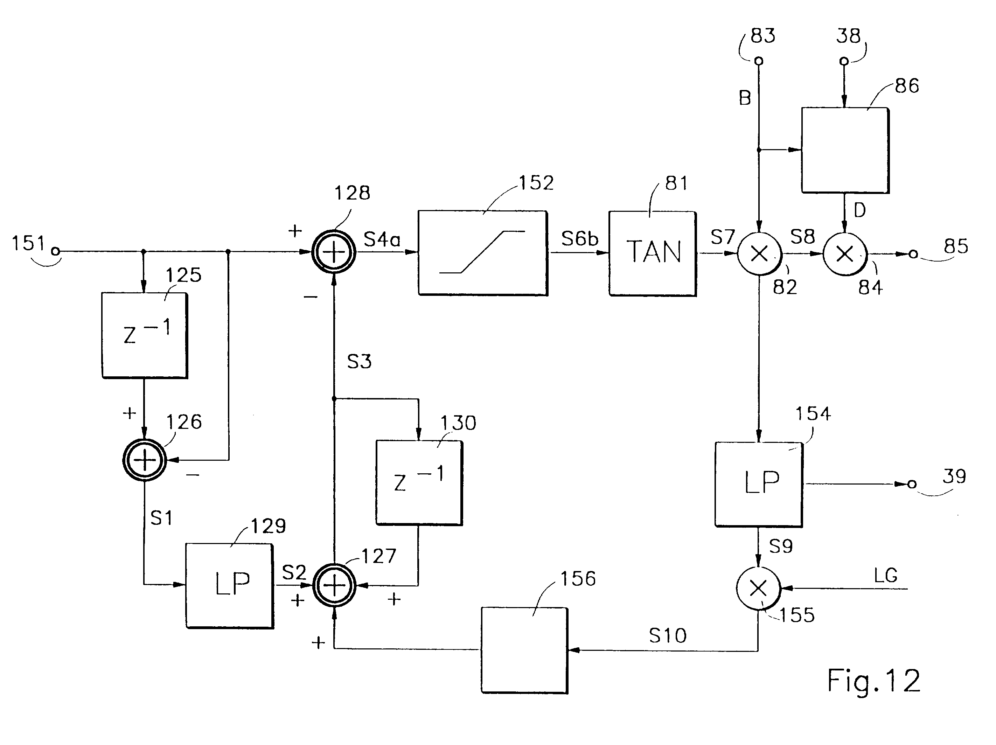

Fig. 12 zeigt eine weitere Ausführungsform des Q-Decoders 48 (Fig. 3), die sich durch einen besonders geringen Klirrfaktor im Differenzkanal L-R auszeichnet. Das bei 151 zugeführte Phasensignal P wird in gleicher Weise wie bei dem Q-Decoder nach Fig. 5, wie bereits im Zusammenhang mit Fig. 9 erläutert, frequenzkorrigiert. Dazu dienen die Modulo-Addierer 126, 127, 128, die Verzögerer 125 und 130 und das Tiefpaßfilter 129. Das frequenzkorrigierte Signal S4b wird über einen Begrenzer 152 geleitet. Das begrenzte Signal S6b wird dann, wie bereits im Zusammenhang mit Fig. 5 erläutert, weiterverarbeitet, nämlich mit einer Schaltung 81 zur Tangensbildung, mit Multiplizierern 82, 84 und mit einer Schaltung 86 zur Erzeugung eines Signals D, welches die Signalqualität kennzeichnet. Zur Ableitung des Pilottonindikators, der am Ausgang 39 zur Verfügung steht, ist bei der Schaltungsanordnung nach Fig. 12 ein Tiefpaßfilter 154 vorgesehen, dessen Ausgangssignal S9 mit einer bei 155 zugeführten Konstante multipliziert, die beispielsweise von einem Geräteprozessor programmierbar ist, und als Signal S10 in ein Register 156 eingeschrieben wird. Aus diesem wird es mit einer höheren Rate ausgelesen und dem Modulo-Addierer 127 zugeleitet. Ist der Phasenfehler zwischen dem unmodulierten Trägersignal und dem Signal S3 0, so ist S8, somit auch S9 und auch S10 gleichanteilsfrei. In allen anderen Fällen sorgt die Rückkopplung des Gleichanteils dafür, daß das Signal S3 in seiner Phase solange verändert wird, bis der Phasenfehler und damit der Gleichanteil von S8 verschwindet. Die Konstante LG bestimmt die Schleifenverstärkung dieser Regelung.

Die im Zusammenhang mit Fig. 12 erläuterte Schaltung benötigt keine n-Korrektur, da bei einem Winkelversatz des Signals S4b um n die Begrenzung 152 aktiv wird und so zu einem großen Gleichanteil im Signal S8 führt. Dieser bewirkt über die Rückkopplung eine Phasenverschiebung von S3, bis der Winkelversatz und damit auch der Gleichanteil S8 vollständig ausgeglichen ist. Der wesentliche Vorteil dieser Schaltung gegenüber der in Fig. 5 angegebenen liegt darin, daß zur Phasenkorrektur der Gleichanteil von S8 und nicht derjenige von S4 gemessen wird. Der Gleichanteil von S8 ist ausschließlich abhängig vom gesuchten Phasenfehler, wogegen der Gleichanteil von S4 zum Teil auch modulationsabhängig ist. Dadurch erzielt der Q-Decoder nach Fig. 12 einen geringeren Klirrfaktor. Der zuvor genannte Vorteil des erfindungsgemäßen Empfängers, daß die Referenzfrequenz bei der Abstimmung nicht mehr an die Frequenz des unmodulierten Sendeträgers gekoppelt werden muß und daß die Frequenzkorrektur hier durch eine Steuerung und nicht durch eine Regelung (PLL) erfolgt, bleiben bestehen.

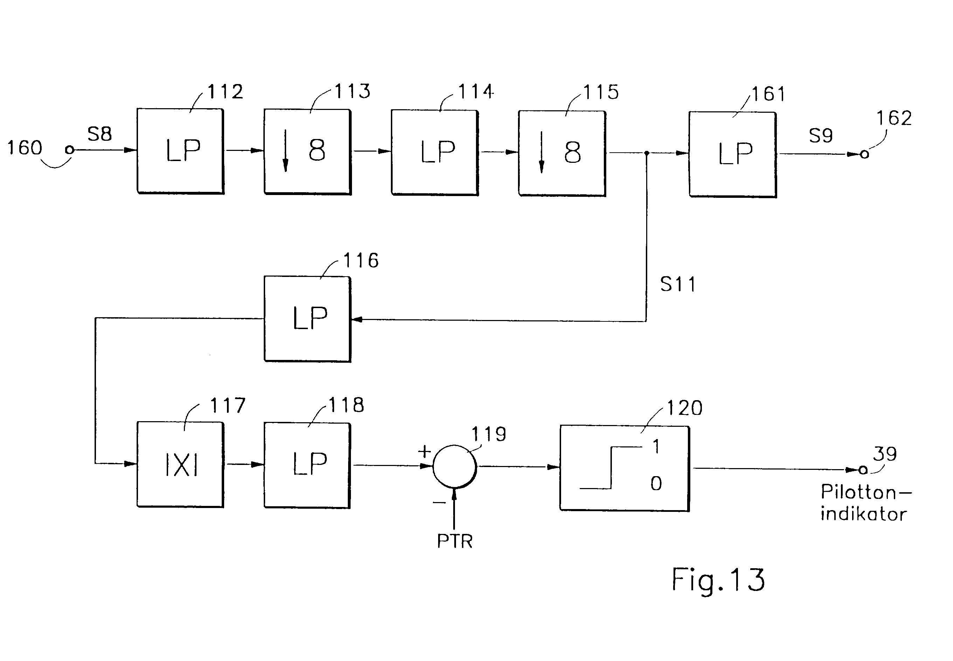

Fig. 13 stellt das Tiefpaßfilter 154 (Fig. 12) dar, das sowohl zur Ableitung des Pilottonindikators als auch zur Erzeugung des Signals S9 dient. Das Signal S8 wird einem Eingang 160 zugeleitet, worauf eine zweifache Abtastratendezimierung mit Tiefpaßfilterung entsprechend der Schaltung nach Fig. 8 mit Hilfe der Teile 112 bis 115 erfolgt. Auch die Ableitung des Pilottonindikators selbst erfolgt in gleicher Weise wie bei der Schaltung nach Fig. 8. Das Ausgangssignal der Abtastratendezimierung 115 wird zur Bildung des Signal S9 über ein Tiefpaßfilter 161 geleitet und ist am Ausgang 162 abnehmbar.

## Patentansprüche

1. Verfahren zur Demodulation eines quadraturamplitudenmodulierten Stereosignals für Rundfunkempfänger, wobei aus einem empfangenen Signal ein digitales Zwischenfrequenzsignal erzeugt wird, wobei das digitale Zwischenfrequenzsignal in das Basisband umgesetzt wird, wobei zwei orthogonale Komponenten (I, Q) gebildet werden, und wobei aus den orthogonalen Komponenten (I, Q) ein Betragssignal (B) abgeleitet wird, dadurch gekennzeichnet, daß aus den orthogonalen Komponenten ein Phasensignal (P) abgeleitet wird, daß aus dem Phasensignal (P) dessen Tangens gebildet wird und daß der Tangens (S7) mit dem Betragssignal (B) zur Bildung eines Stereo-Differenzsignals (L-R) multipliziert wird.

2. Verfahren nach Anspruch 1, dadurch gekennzeichnet, daß das Phasensignal (P) vor der Tangensbildung bezüglich Frequenz- und Phasenabweichungen des ins Basisband umgesetzten Zwischenfrequenzsignals korrigiert wird.

3. Verfahren nach Anspruch 2, dadurch gekennzeichnet, daß zur Korrektur bezüglich Frequenzabweichungen vom Phasensignal (P) ein Korrektursignal (S3) subtrahiert wird, das durch Messung der zeitlichen Änderung des Phasensignals (P), anschließende Tiefpaßfilterung und Integration des tiefpaßgefilterten Signals (S2) gefiltert wird.

4. Verfahren nach einem der Ansprüche 2 oder 3, dadurch gekennzeichnet, daß von dem bezüglich der Frequenzabweichung bereits korrigierten Phasensignal (S4) ein weiteres Korrektursignal (S5) subtrahiert wird, das durch Tiefpaßfilterung des bezüglich der Frequenz korrigierten Phasensignals (S4) abgeleitet wird.

5. Verfahren nach einem der Ansprüche 2 bis 4, dadurch gekennzeichnet, daß dem bereits bezüglich der Frequenzabweichung korrigierten Phasensignal (S4a) ein weiters Korrektursignal (Skorr) hinzugefügt wird, das zwei verschiedene Pegel annehmen kann, welche Phasenabweichungen entsprechen, die um π voneinander verschieden sind, und daß das weitere Korrektursignal (Skorr) durch Betragsbildung und Tiefpaßfilterung des bezüglich der Frequenzabweichung korrigierten Phasensignals (S4a) und mit Hilfe einer anschließenden Schwellwertschaltung (139) mit Hysterese gebildet wird.

6. Verfahren nach Anspruch 3, dadurch gekennzeichnet, daß dem die zeitliche Änderung des Phasensignals kennzeichnenden und anschließend tiefpaßgefilterten Signal ein Rückkopplungssignal zugeführt wird, das aus dem Stereo-Differenzsignal (L-R) durch Tiefpaßfilterung gewonnen wird, und daß das bezüglich der Frequenzabweichung korrigierte Phasensignal (S4a) über einen Begrenzer (152) zur Tangensbildung geleitet wird.

## Claims

1. Method for demodulating a quadrature-amplitude-modulated stereo signal for radio receivers, a digital intermediate-frequency signal being generated from a received signal, the digital intermediate-frequency signal being converted into the baseband, two orthogonal components (I, Q) being formed, and an absolute-value signal (B) being derived from the orthogonal components (I, Q), characterized in that a phase signal (P) is derived from the orthogonal components, in that the tangent of the phase signal (P) is formed therefrom, and in that the tangent (S7) is multiplied by the absolute-value signal (B) to form a stereo differential signal (L-R).

2. Method according to Claim 1, characterized in that before the tangent is formed the phase signal (P) is corrected with respect to frequency deviations and phase deviations of the intermediate-frequency signal converted into the baseband.

3. Method according to Claim 2, characterized in that for the purpose of correction with respect to frequency deviations there is subtracted from the phase signal (P) a correction signal (S3) which is filtered by measuring the temporal change in the phase signal (P), subsequently carrying out low-pass filtering and integrating the low-pass-filtered signal (S2).

4. Method according to one of Claims 2 or 3, characterized in that there is subtracted from the phase signal (S4) already corrected with respect to the frequency deviation a further correction signal (S5) which is derived by carrying out low-pass filtering of the phase signal (S4) corrected with respect to the frequency.

5. Method according to one of Claims 2 to 4, characterized in that there is added to the phase signal (S4a) already corrected with respect to the frequency deviation a further correction signal (Skorr), which can assume two different levels which correspond to phase deviations which differ from one another by π, and in that the further correction signal (Skorr) is formed by absolute-value generation and low-pass filtering of the phase signal (S4a), corrected with respect to the frequency deviation, and with the aid of a subsequent threshold-value circuit (139) with hysteresis.

6. Method according to Claim 3, characterized in that there is fed to the signal characterizing the temporal change in the phase signal and subsequently subjected to low-pass filtering a feedback signal which is obtained by low-pass filtering from the stereo differential signal (L-R), and in that the phase signal (S4a) corrected with respect to the frequency deviation is led via a limiter (152) for the purpose of forming the tangent.

## Revendications

1. Procédé de démodulation d'un signal stéréo, modulé en amplitude et déphasé en quadrature, pour récepteurs radio, dans lequel on produit à partir d'un signal reçu un signal numérique de fréquence intermédiaire, le signal numérique de fréquence intermédiaire étant transformé dans la bande de base, un signal de valeur absolue (B) étant prélevé à partir de deux composantes orthogonales (I, Q),
caractérisé en ce que
• l'on prélève à partir des composantes orthogonales un signal de phase (P),
• l'on forme à partir du signal de phase (P) sa tangente et
• l'on multiplie la tangente (S7) par le signal de valeur absolue (B) pour former un signal différentiel stéréo (L - R).

2. °)Procédé selon la revendication 1,
caractérisé en ce que
le signal de phase (P) est corrigé avant la formation de sa tangente en ce qui concerne les écarts de fréquence et de phase du signal de fréquence intermédiaire transformé dans la bande de base.

3. Procédé selon la revendication 1,
caractérisé en ce que
pour effectuer la correction en ce qui concerne le écarts de fréquence on soustrait du signal de phase (P) un signal de correction (S3) qui est filtré en mesurant la variation dans le temps du signal de phase (P), en effectuant ensuite son filtrage à travers un filtre passe-bas, et en intégrant le signal (S2), filtré à travers un filtre passe-bas.

4. Procédé selon l'une des revendications 2 ou 3,
caractérisé en ce que
l'on soustrait du signal de phase (S4) déjà corrigé en ce qui concerne l'écart de fréquence, un autre signal de correction (S5) qui est prélevé en filtrant à travers un filtre passe-bas le signal de phase (S4), corrigé en ce qui concerne la fréquence.

5. Procédé selon l'une des revendications 2 à 4,
caractérisé en ce que
• l'on ajoute au signal de phase (S4a) déjà corrigé en ce qui concerne l'écart de fréquence, un autre signal de correction (Skorr) qui peut prendre deux niveaux différents qui correspondent à des déphasages qui diffèrent de π l'un de l'autre, et
• l'on forme avec hystérésis l'autre signal de correction (Skorr) en formant la valeur absolue et en effectuant un filtrage à travers un filtre passe-bas du signal de phase (S4a), corrigé en ce qui concerne l'écart de fréquence, et avec l'aide d'un circuit de valeur de seuil (139) qui fait suite.

6. Procédé selon la revendication 3,
caractérisé en ce que
• l'on amène au signal qui caractérise la variation dans le temps du signal de phase et que l'on filtre ensuite à travers un filtre passe-bas, un signal de rétroaction qui est obtenu à partir du signal différentiel stéréo (L - R), par filtrage à travers un filtre passe-bas, et
• l'on fait passer le signal de phase (S4a), corrigé en ce qui concerne l'écart de fréquence, sur un limiteur (152) pour former sa tangente.
